# EUROPÄISCHE PATENTSCHRIFT

(11) **EP 3 944 490 B1**
(45) Veröffentlichungstag und Bekanntmachung des Hinweises auf die Patenterteilung: **06.03.2024**
(21) Anmeldenummer: 21187774.1
(22) Anmeldetag: 26.07.2021
(51) Int. Cl.: H02S 20/22, H02S 30/00

(54) **HALTEVORRICHTUNG ZUM LÖSBAREN BEFESTIGEN EINES SOLARMODULS**
HOLDING DEVICE FOR REVERSIBLY FIXING A SOLAR MODULE
DISPOSITIF DE RETENUE PERMETTANT DE FIXER AMOVIBLE UN MODULE SOLAIRE

(30) Priorität: 24.07.2020 DE 202020104266 U
(43) Veröffentlichungstag der Anmeldung: 26.01.2022
(73) Patentinhaber: SOLAR-HOOK GmbH, 79108 Freiburg (DE)
(72) Erfinder: Schammel, Mark, 79108 Feiburg (DE)
(74) Vertreter: Misselhorn, Hein-Martin

(56) Entgegenhaltungen:
- CN-U- 207 053 452
- JP-A- 2014 031 922
- KR-A- 20140 119 230
- KR-B1- 101 429 633
- KR-B1- 101 751 643
- KR-B1- 101 813 453
- KR-U- 20160 000 769

## Beschreibung

Die Erfindung betrifft einen Halter zum Befestigen eines Solarmoduls an einer Stange nach dem Oberbegriff des Anspruchs 1 sowie eine Solaranlage, deren Solarmodule mit entsprechenden Haltern an mindestens einer Stange installiert sind.

### TECHNISCHER HINTERGRUND

Im Zuge des immer weiter steigenden Umweltbewusstseins erfreuen sich besonders kleine Photovoltaiksysteme stark steigender Beliebtheit. Diese kleinen Photovoltaiksysteme werden oft auch Mini-Solaranlagen, Plug & Play-Solaranlagen oder Balkonmodule genannt, weil sie sich beispielsweise an die Balkonbrüstung montieren lassen. Der von diesen Balkonmodulen erzeugte Strom wird typischerweise über einen Wechselrichter und einen Schuko-Stecker in die Steckdose einer Wohnung eingespeist. Die Systeme sind typischerweise so dimensioniert, dass dadurch der in der Wohnung verbrauchte Strom teilweise von den Balkonmodulen aufgebracht wird und daher weniger Strom aus dem öffentlichen Netz zugespeist werden muss, um den Strombedarf der Wohnung zu decken. Eine Einspeisung in das öffentliche Netz erfolgt kaum.

Aufgrund dessen handelt es sich bei diesen Systemen nicht um Photovoltaikanlagen im bau- oder energierechtlichen Sinne. Stattdessen werden diese Systeme als genehmigungsfreie stromerzeugende Haushaltsgeräte eingestuft; sie laufen unter dem Fachbegriff Steckbare Solargeräte. Daher sind solche Systeme vorwiegend auch für Mieter oder Besitzer von Eigentumswohnungen interessant. Gerade Mieter oder Besitzer von Eigentumswohnungen sind allerdings an einer besonders einfachen Installation der Systemkomponenten interessiert, um diese beim Auszug aus der Mietwohnung mitnehmen und anderweitig verwenden zu können.

Vor diesem Hintergrund ist klar, warum vermehrt Bedarf besteht, Solarmodule außenseitig an Balkongeländern anzubringen. Es ist bekannt, hierfür metallene Konsolen zu verwenden, die mit dem Balkongeländer verschraubt werden und an denen die Solarmodule angeschraubt sind. Aus Sicherheitsgründen müssen die Solarmodule jeweils mehrfach mit den sie tragenden Konsolen verschraubt werden.

Die KR 2014 0119230 A beschreibt eine Photovoltaik-Kollektorplatten-Befestigungsvorrichtung für einen Balkonzaun zum Anbringen einer Photovoltaik-Kollektorplatte an einem Balkonzaun, der für jeden Haushalt vorgesehen ist und der ein optimaler Sonnenplatz mit viel Sonnenschein sein kann. Vertikale Stäbe sind an beiden Seiten einer Rückfläche eines Rahmens einer Photovoltaik-Kollektorplatte mit einem Solarpanel gekoppelt, um voneinander beabstandet zu sein. Die oberen Teile der vertikalen Stäbe sind mit dem oberen horizontalen Stab eines Zauns als oberes Kopplungsmittel gekoppelt. Die unteren Teile der vertikalen Stäbe sind mit den unteren horizontalen Stäben des Zauns durch einen Träger verbunden. Der Träger weist eine Neigung auf, damit der optimale Neigungswinkel der Photovoltaik-Kollektorplatte eingestellt werden kann. Daher kann die Photovoltaik-Kollektorplatte unabhängig von der Anzahl der Haushalte und der Fläche installiert werden, kann umweltfreundlich sein und Energie sparen.

Die KR 2016 0000769 U betrifft eine Technologie, die in der Lage ist, Elektrizität unter Verwendung von Sonnenlicht zu erzeugen, und insbesondere eine Solarpanel-Installationsstruktur, die kompakt und bequem an einem Verandageländer einer Wohnung usw. installiert werden kann.

### DIE DER ERFINDUNG ZUGRUNDE LIEGENDE AUFGABE

Der Erfindung liegt die Aufgabe zugrunde, Konsolen für Solarmodule anzugeben, die sich einfacher montieren lassen als die bisher bekannten Halter.

### ZUSAMMENFASSUNG DER ERFINDUNG

Die Erfindung ist durch den Gegenstand des unabhängigen Anspruchs 1 definiert. Vorteilhafte Weiterbildungen sind Gegenstand der abhängigen Ansprüche.

### VORTEILE DER ERFINDUNG

Die erfindungsgemäße Lösung erfolgt durch einen Halter gemäß Anspruch 1. Der Halter dient zum Befestigen eines Solarmoduls an einer Stange. Meist ist diese Stange der oberseitig am Balkon- oder Terrassengeländer abschließende Handlauf. Es ist aber natürlich auch denkbar, andere sich anbietende Stangen zu verwenden, etwa Stangen, die an Steildächern als Schneefang dienen. Erfindungsgemäß weist der Halter ein zum Umgriff der jeweiligen Stange geeignetes Formschlusselement auf. Das Formschlusselement kann eine Rohrschelle oder ein Stahlseil sein. Es ist aber in den meisten Fällen als Haken mit einem einseitig offenen Hakenmaul ausgebildet, weil ein solcher eindeutig am zweckmäßigsten ist. Denn mithilfe eines solchen Hakens kann der Halter ähnlich wie der eines Blumenkastens in den Handlauf des Balkongeländers eingehängt werden. So lassen sich selbst gewichtige Solarpanels rückbaubar an dem Geländer bzw. dessen Handlauf befestigen - ohne bauliche Veränderungen am Geländer oder Gebäude vornehmen zu müssen oder Gefahr zu laufen, das Geländer bzw. seine Beschichtung zu beschädigen oder zu verkratzen.

Darüber hinaus bildet der Halter einen Halteflansch aus, der sicher mit dem zu haltenden Solarmodul verbunden werden kann. Der Halteflansch liegt bei bestimmungsgemäßem Einbau des Halters bevorzugt unterhalb des Hakens zum Einhängen am Geländer. So trägt das Eigengewicht der Solarpanels dazu bei, den Halt zu verbessern, den der Halter bietet. Denn der Halter hat bei dieser Ausgestaltung immer die Tendenz, unter dem Einfluss der Gewichtskraft des Solarpanels in Richtung hin zum Balkongeländer zu schwenken. Das reduziert die Seitenwindanfälligkeit.

Der Halteflansch besitzt mindestens eine Öffnung, über die der Halteflansch mit den Solarpanels verschraubt werden kann. Der patentrechtlichen Vollständigkeit halber sei gesagt, dass auch ein Vernieten denkbar wäre, typischerweise mithilfe von PopNieten.

Optional besitzt der Halteflansch auf seiner bei bestimmungsgemäßer Montage dem Balkongeländer zugewandten Seite eine - meist plane - Stützfläche. Hierüber kann sich der Halteflansch bei Bedarf gegen das Geländer oder einen sonstigen Gebäude- oder Anlagenteil abstützen. Bevorzugt trägt die Stützfläche einen meist weichelastischen Schutzbelag oder einen separaten Gummi, um das Geländer an der Abstützstelle zu schonen. In anderen, zahlenmäßig überwiegenden Fällen erfolgt diese Abstützung über die Solarpanels selbst, die dann zu diesem Zweck an ihrer Unterseite mit einem Horizontalprofil versehen sind, das sich z. B. am Balkongeländer abstützt.

Eine weitere Besonderheit an dem erfindungsgemäßen Halter ist, dass er mehrere Laschen aufweist. Die Laschen ermöglichen es, dass das besagte Solarmodul (in manchen Ausnahmefällen auch ein sonstiger zu haltender Gegenstand) vor dem Verschrauben formschlüssig in den Halteflansch eingehängt wird. Die aus den Laschen geformten Haken können industriell vorgebogen sein, oder vom verarbeitenden Handwerker in die benötigte Form gebogen werden. Die Laschen haben typischerweise eine Länge von weniger als 30 mm. In vielen Fällen beträgt ihre Breite weniger als 10 mm. Sie machen im Regelfall flächenmäßig nur einen kleinen Teil der Fläche des Montageflansches aus, meist weniger als 15%. Solche Laschen lassen sich gut mit Handwerkzeug biegen und erleichtern daher die Verarbeitung. Die Laschen können an ihrem freien Ender verrundet sein. Sie können eine Gestaltung aufweisen, die als Einführhilfe oder -schräge fungiert und das Einhängen der Laschen erleichtert.

Die Gesamtheit dieser Maßnahmen vereinfacht die Montage beträchtlich. Auch wenn das sicherlich nicht zwingend ist, kann man in vielen Fällen so vorgehen wie nachfolgend geschildert: Die Halter werden mit den Haken, die ihre Laschen bilden, am Modul fixiert, in dem sie nun mechanisch am Rahmen klemmen. Jetzt kann bequem eine Schraube durch die Löcher am Halter und dem Modul gesteckt werden und eine Verschraubung vorgenommen werden. Dann kann die gesamte Einheit einfach am Geländer eingehängt werden, gegebenenfalls nach dem zuvor noch ein Gummi oder sonstiger Schoner gesetzt worden ist um das Geländer zu schonen. Aufgrund der erfindungsgemäßen Haken ist es nun ganz einfach, das fertig an seinen Haltern befestigte Solarpanel in seine Endposition zu hängen - so, dass es auf der Außenseite der Balkonbrüstung zu liegen kommt. Nun müssen nur noch die Haken gegen Aushängen gesichert werden, hierzu im Detail später.

Diese Lösung zeichnet sich auch dadurch aus, dass eine höhere Sicherheit erreicht wird als bei einer bloß einfachen Verschraubung.

Idealerweise sind die Laschen so angeordnet, dass die Verschraubung zwischen dem Montageflansch und dem Solarpanel erst dann hergestellt werden kann, wenn das betreffende Solarpanel korrekt in die Laschen eingehängt worden ist. Ist das nicht der Fall, dann kommt die Öffnung in dem Halteflansch nicht hinreichend mit dem Gegenstück im Solarpanel zur Überdeckung, um eine Verschraubung herstellen zu können.

### WEITERE MÖGLICHKEITEN, DIE ERFINDUNG OPTIONAL AUSZUGESTALTEN

Besonders günstig ist es, wenn die Laschen integraler Bestandteil des Halteflansches sind, also einstückig mit ihm verbunden sind.

Für den Haken zum Aufhängen an Balkongeländern gilt, dass er natürlich ein an den Montageflansch angeschraubter Bestandteil sein kann. Bevorzugt ist aber auch der Haken integral an den Halteflansch angeformt, also einstückig mit ihm verbunden. Eine solche Ausgestaltung erleichtert die Herstellung als Massenteil ungemein. Denn der Halter kann dann als einstückiges Blechbiegeteil hergestellt werden oder als einstückige Scheibe, die von einem entsprechenden Strangpressprofil abgetrennt wird.

Besonders günstig ist es, wenn die Laschen im Auslieferungszustand nicht von dem Halteflansch abstehen. Typischerweise ist das dann der Fall, wenn sie mit dem zumindest überwiegend planen Halteflansch in einer Ebene liegen bzw. ihre Mittelinie parallel zu der des Halteflansches liegt. Um dies zu gewährleisten, geht man vorzugsweise so vor, dass die Laschen im Auslieferungszustand, vor dem Montage-Fertigmachen auf der Baustelle, nur an einem Ende integral mit dem Halteflansch verbunden sind. Ansonsten sind sie durch ein Schlitz von ihm abgetrennt. Ist der Halter ein Blechteil, dann werden die Laschen werkseitig teilausgestanzt, aber bevorzugt noch nicht ausgeklinkt.

Eine solche Anlieferung der Halter auf die Baustelle hat den Vorteil, dass die Halter platzsparender verpackt werden können und nicht die Tendenz haben, ineinander zu verhaken. Die möglichst platzsparende Verpackung ist insbesondere dann von Interesse, wenn die Halter preisgünstig in Übersee gefertigt werden und daher teuren Frachtraum benötigen, um an ihr Ziel zu gelangen.

Im Übrigen hat eine solche Anlieferung der Halter auf die Baustelle auch den Vorteil, dass die Möglichkeit besteht, ein und denselben Halter sehr einfach für die Montage unterschiedlicher Typen von Solarpanels zu verwenden. Denn der Monteur kann ja die noch jungfräuliche, ebene Lasche auf der Baustelle in die individuell benötigte Hakenform bringen. Dies geschieht oft Freihand mit einer Zange. Gerade bei guter Zugänglichkeit der Laschen infolge ihrer Randlage am Montageflansch kann der Monteur mit einer seiner universellen Zangen arbeiten, die er ohnehin zur Hand hat. Gerade dort, wo Großprojekte bewältigt werden müssen, können den Monteuren aber auch spezielle Absetzzangen an die Hand gegeben werden. Die Backen dieser Absetzzangen sind so geformt, dass sich die Laschen mit einem einzigen Zangendruck in immer die gleiche Form bringen lassen. Manchmal wird es vorteilhaft sein, den Monteuren unterschiedliche Absetzzangen an die Hand zu geben. So gelingt es sehr rationell und ohne viel Nachdenken, aus immer den gleichen Laschen unterschiedlich geformte Haken zu machen für unterschiedliche Typen von Solarpanels.

Es kann aber auch noch einfacher vorgegangen werden, beispielsweise beim Verkauf an Heimwerker. Es bietet sich nämlich an, jeden oder zumindest einige der Halter mit einer Formgebung auszustatten, die sie zum Biegewerkzeug macht, mittels dessen Laschen anderer solcher Halter in die gewünschte Form gebogen werden können. Zu diesem Zweck kann der Halter ganz einfach mit einer Nut versehen werden. Diese Nut ist so geformt, dimensioniert und ausgerichtet, dass in sie grade auch die noch ebene Lasche eines anderen Halters eingehängt werden kann - derart, dass besagte Lasche durch Drehen und Schwenken des Halters mit der Nut in die gewünschte Form gebogen werden kann. Das Ende des Hakens wird - optional - für die doppelte Materialstärke umgebördelt, da sich sonst das schwächere Material biegt.

Schließlich ist noch anzumerken, dass eine solche Anlieferung der Halter auf die Baustelle gerade auch dann einen Vorteil hat, wenn der Halter mit diversen Laschen ausgestattet ist, um möglichst universell einsatzfähig zu sein. Denn dann ist es bei eben angelieferten Laschen so, dass nicht benötigte Laschen nicht stören. Denn sie sind nicht durch Umbiegen aufgestellt und damit aktiviert, sondern bleiben in einer Ebene mit dem Montageflansch.

Natürlich können die erfindungsgemäßen Halter auch so gestaltet sein, dass sie verwendungsfertig geliefert werden. Ihre Laschen sind dann von Anfang an so gebogen bzw. positioniert und ausgerichtet, dass das freie Ende der Lasche in einer Ebene liegt bzw. in eine Ebene ragt, die vom Montageflansch beanstandet ist und die von ihm eingenommene Ebene(n) auch nicht schneidet. Die Lasche kann dabei eine runde, polygonale oder eckige Hakenform einnehmen.

Weitere Möglichkeiten für die weitere Ausgestaltung des erfindungsgemäßen Halters beschreiben die verschiedenen Unteransprüche.

Darüber hinaus ergeben sich weitere Ausgestaltungsmöglichkeiten, Wirkungsweisen und Vorteile der Erfindung aus der nachfolgenden Beschreibung eines konkreten Ausführungsbeispiels der Erfindung.

### FIGURENLISTE

Die Figur 1 zeigt einen verwendungsfertigen Halter in perspektivischer Darstellung.
Die Figur 2 zeigt einen Rohling eines solchen Halters vor dem Anformen seines Hakens zum Aufhängen am Geländer.
Die Figur 3 zeigt eine Draufsicht auf einen solchen Halter von der hakenabgewandten Breitseite her gesehen.
Die Figur 4 zeigt eine Seitenansicht des Halters gemäß Figur 3., jedoch nach Verformung aller Laschen zu Haken.
Die Figur 5 zeigt eine Stütze die zusammen mit den erfindungsgemäßen Haltern zum Einsatz kommen kann um ein Haltersystem zu bilden.
Die Figur 6 zeigt eine Draufsicht auf die von Fig. 5 gezeigte Stütze.
Die Fig. 7 zeigt ein in Bezug auf seine Laschen 2 abgewandeltes Ausführungsbeispiel

### AUSFÜHRUNGSBEISPIEL

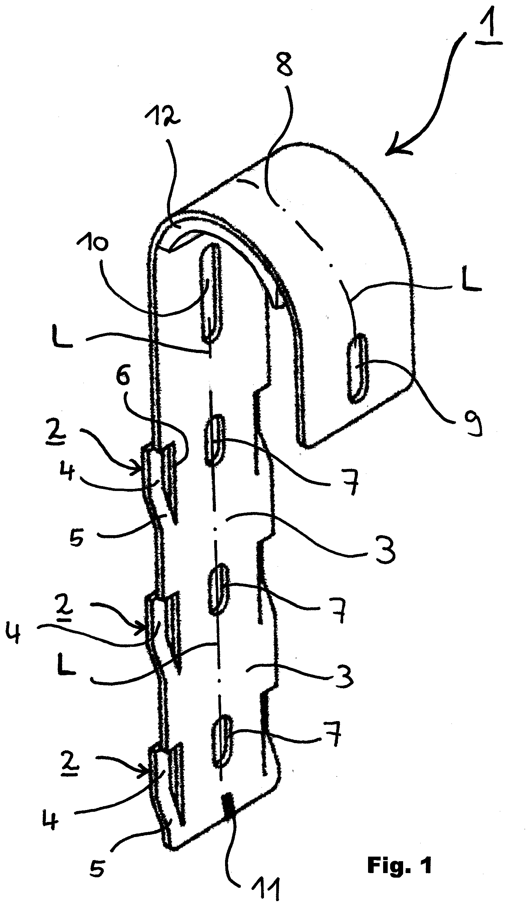

Am anschaulichsten lässt sich der erfindungsgemäße Halter 1 anhand der Figur 1 beschreiben.

Die Figur 1 zeigt den bereits vollständig einsatzbereiten Halter 1. In dessen Laschen 2 kann nun unmittelbar ein Solarpanel eingehängt werden. Zu diesem Zweck weisen die Laschen 2 eine Hakenform auf. Die Laschen 2 können entweder bereits werkseitig diese Form erhalten haben oder der Monteur hat ihnen auf der Baustelle durch entsprechendes Biegen mit einem Handwerkzeug diese Form verliehen.

Wie man sieht, umfasst der Halter 1 einen Montageflansch 3. Der Montageflansch 3 trägt bevorzugt an seinen Seiten, bei diesem Ausführungsbeispiel entlang seiner längeren Seiten, die besagten Laschen. Die gezeigte seitliche Anbringung der Laschen hat den Vorteil, dass diese sehr gut zugänglich sind. So lassen sie sich sehr einfach durch Biegen in die gewünschte Form biegen. Weniger günstig, aber dennoch möglich, ist es, die Laschen mitten in dem Montageflansch 3 auszuklinken, dann idealerweise symmetrisch zu dessen Längsachse L. Dies wird hier allerdings wegen der geringeren Bedeutung nicht figürlich dargestellt.

Die Hakenform der Laschen 2 kann variieren. In manchen Fällen sind Rundhaken besonders günstig, vor allem dann, wenn eine vollständige industrielle Vorfertigung erfolgt. In anderen Fällen ist für die Laschen 2 eine Hakenform klar bevorzugt, die aus zwei geradlinigen Abschnitten besteht, so wie es hier beispielhaft gezeigt ist. Solche Laschen 2 bilden dann einen Haken, indem sie so verformt sind, dass sie einen geradlinigen Kopfabschnitt 4 bilden, der idealerweise parallel mit Abstand zu der vom Montageflansch 3 aufgespannten Ebene liegt. An den geradlinigen Kopfabschnitt 4 schließt sich ein Fußabschnitt 5 des Hakens an. Der Haken ist nur noch über diesen Fußabschnitt 5 mit dem Montageflansch verbunden. Der Fußabschnitt 5 verläuft vorzugsweise schräg zu der vom Montageflansch 3 aufgespannten Ebene. Der überwiegende Teil der diesen Haken bildenden Lasche ist durch einen Schlitz 6 vom Flanschabschnitt 3 abgetrennt.

Gut zu erkennen ist, dass der Montageflansch 3 des Halters 1 mindestens eine, vorzugsweise (so wie hier gezeigt) mehrere Öffnungen 7 aufweist. Jede dieser Öffnungen 7 ermöglicht es, den Montageflansch 3 mit dem nicht gezeigten Solarpanel zu verschrauben. Wie schon oben angeklungen ist, sind die Öffnungen 7 und die Laschen 2 vorzugsweise so relativ zueinander positioniert, dass die Öffnungen 7 nur dann von einer Schraube durchgriffen werden können, dass eine Verschraubung mit dem Solarpanel möglich ist, wenn das Solarpanel korrekt in die Laschen 2 eingehängt worden ist.

Gut anhand der Figur 1 zu erkennen ist auch der Haken 8. Es ist zunächst nicht ausgeschlossen, dass der Haken 8 ein gesondertes Teil darstellt. Dieses gesonderte Teil kann durch Verschrauben, Vernieten oder Verschweißung mit dem Montageflansch 3 verbunden sein. Die klar bevorzugte Lösung ist allerdings die, die die Figur 1 zeigt. Hier geht der Montageflansch 3 integral in den Haken 8 über. Der Haken 8 ist hier als Rund- bzw. Halbrund-Haken ausgeführt. Damit ist der Tatsache Rechnung getragen, dass die meisten Handläufe, die den Abschluss eines Balkongeländers bilden, rund sind. Um anderen Fällen Rechnung zu tragen, kann der Haken aber natürlich auch kantig sein, beispielsweise, um einen Handlauf in Gestalt eines Kantrohrs oder einer kantigen Holzleiste zu übergreifen. In wieder anderen Fällen mag der Haken eine regelmäßige oder unregelmäßige Polygonform haben.

Bemerkenswert ist, dass der Haken bevorzugt weitere Öffnungen 9 und 10 aufweist. Die Öffnung 9 ist meist im Bereich des freien Hakenendes ausgeführt. Die Öffnung 10 ist meist in der Nähe des Hakenfußes ausgeführt. Die Öffnungen 9 und 10 sind dabei idealerweise so angeordnet, dass sie sich im Wesentlichen in horizontaler Richtung gegenüberliegen, wenn der Montageflansch eine Vertikalposition einnimmt. Diese Öffnungen haben die Funktion, das Hakenmaul schließen zu können. Denn sie dienen dazu, einen Sicherungsbolzen aufzunehmen, bevorzugt in Gestalt einer Durchsteckschraube. Dabei kann eine der Öffnungen ein Gewinde tragen. Das Einführen des Sicherungsbolzens wird wesentlich vereinfacht, wenn wenigstens eine der Öffnungen 9, 10 ein Langloch ist, das sich entlang der Halterlängsachse erstreckt. Idealerweise ist die Öffnung ein Langloch, die der Bolzen beim Einschieben später erreicht, also die Öffnung 10 im Bereich des Hakenfußes. Das erleichtert das sofortige Treffen dieser Öffnung mit dem Bolzen.

Gut anhand der Figur 1 ist auch zu erkennen, dass die mit dem Handlauf in Kontakt kommende Innenseite des Hakens einen meist weichelastischen Schutzbelag trägt, um das Geländer an der Abstützstelle zu schonen.

Bevorzugt im Bereich seiner dem Haken abgewandten, schmalen Stirnseite ist in das Material des Montageflansches eine Nut 11 eingearbeitet. Die Nut ist unwesentlich breiter als die Materialdicke der Laschen dieser Halter. Sie ist so tief, dass die Nut in der bereits oben angesprochenen Art und Weise über eine Lasche eines anderen Halters geschoben werden kann, um diese durch Drehen und Schwenken des die Nut tragenden Halters in die gewünschte Form zu bringen. Besonders bevorzugt ist es, wenn der Halter an diesem Ende um 180° umgebördelt ist und die Nut auch im umgebördelten Teil ausgebildet ist - hierdurch wird ein entsprechend stabiles Werkzeug zur Verfügung gestellt.

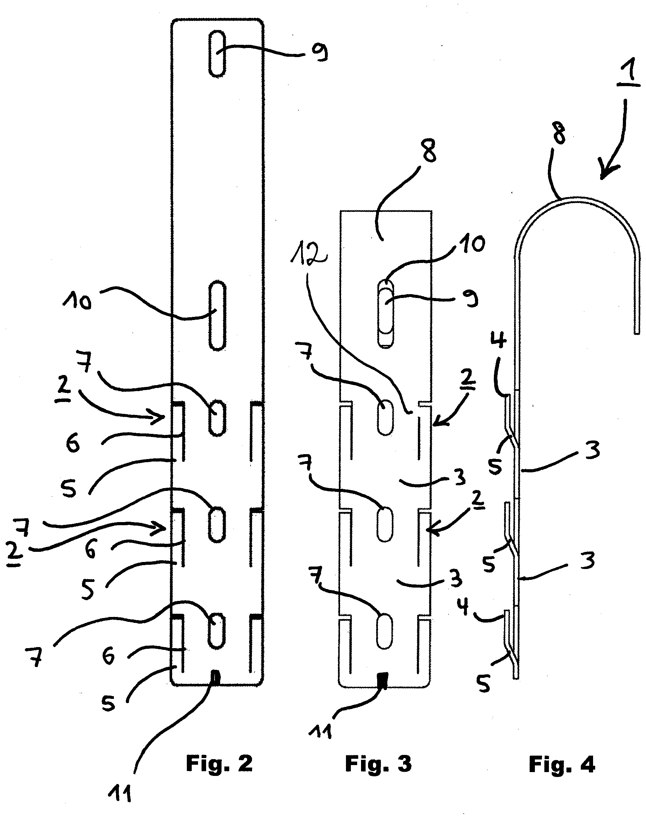

Darüber hinaus ist die Figur 2 von besonderem Interesse. Sie zeigt das oben erörterte Ausführungsbeispiel als Halbfertigprodukt, vor dem Biegen des Hakens. Wie man sieht, ist zur Herstellung ein rechteckiger, von Haus aus zunächst ebener Blechstreifen verwendet worden. Seine Erstreckung in Richtung seiner Längsachse L ist mindestens fünfmal, besser mindestens achtmal größer als seine Erstreckung senkrecht dazu. Seine Dicke ist typischerweise kleiner oder gleich 10 mm, in vielen Fällen sogar kleiner oder gleich 5 mm. Als Material kommt bevorzugt Edelstahl oder verzinktes Stahlblech zum Einsatz. Edelstahl ist deutlich vorzuziehen, da bei verzinktem Stahlblech die Gefahr besteht, dass die erst nach dem Verzinken ausgestanzten Strukturen - darunter nicht zuletzt die Seitenbereiche der sicherheitsrelevanten Laschen - an ihren blanken Schnittflächen korrodieren.

Wie schon erwähnt, ist nochmals zu erkennen, dass der spätere Montageflansch bevorzugt mindestens drei Reihen in Richtung der Längsachse L hintereinander liegender Laschen 2 aufweist. Auch wäre denkbar das diese 3 Reihen auf nur eine reduziert werden. Dabei besteht jede Reihe aus Laschen, bevorzugt aus mindestens zwei Laschen, nämlich einer außenseitig an der linken langen Stirnseite liegenden Lasche und einer außenseitig an der rechten langen Stirnseite liegenden Lasche.

Anzumerken ist noch, dass sich bei einer Konstruktion, wie der von der Figur 2 gezeigten, unterhalb der letzten Reihe von Laschen ein weiterer, hier nicht figürlich dargestellter Fortsatz des Blechstreifens befinden kann. Dieser wird gegebenenfalls ein oder mehrfach abgekantet, um eine Auflage oder einen Lagerbock zu bilden, mit der bzw. dem sich der Halter beispielsweise gegenüber einer in Relation zu dem Handlauf in horizontaler Richtung versetzten Struktur des Balkongeländers abstützen kann.

Speziell mit nochmaligem Blick auf die Figur 1 ist anzumerken, dass der Halter (in Bezug auf seine Montageposition gesehen) bevorzugt erst mehr als 120 mm, besser erst mehr als 140 mm unterhalb des Hakens endet. Auf diese Art und Weise kann sich der Halter hinreichend gut gegenüber der dahinter liegenden Struktur des Balkongeländers abstützen.

Speziell unter Verweis auf Fig. 3 ist noch auf Folgendes aufmerksam zu machen: Vorzugsweise in dem Bereich des Endes der Lasche 2, das ggf. später ein freies Hakenende ausbildet, wird zunächst ein Mikrosteg 12 gelassen.

Dieser stabilisiert die Lasche gegenüber dem Montageflansch, falls sie nicht zu einem Haken verformt wird. Am Beispiel der rechten oberen Lasche, die in Fig. 3 erkennbar ist, wird der Mikrosteg visualisiert. Solche Mikrostege können aber optional bei allen nicht verformten Laschen vorhanden sein.

Gesagt sei noch, dass optional eine Oberflächenbehandlung vorgesehen ist, wie Beizen, Chromatieren, Lackieren oder Verzinken.

Idealerweise bilden die erfindungsgemäßen Halter 1 mit zusätzlichen Stützen ein Haltersystem. Die Halter 1 werden oberseitig an dem zu haltenden Gegenstand, der meist ein Solarpanel ist, befestigt, wie oben geschildert. Unterseitig wird eine Stütze an dem zu haltenden Gegenstand befestigt, mit der er zusätzlich festgelegt bzw. abgestützt wird, etwa an dem Balkongeländer, an dessen Handlauf die Halter 1 eingehängt sind, ansonsten alternativ auch am Gebäude, etwa an der Bodenplatte des Balkons.

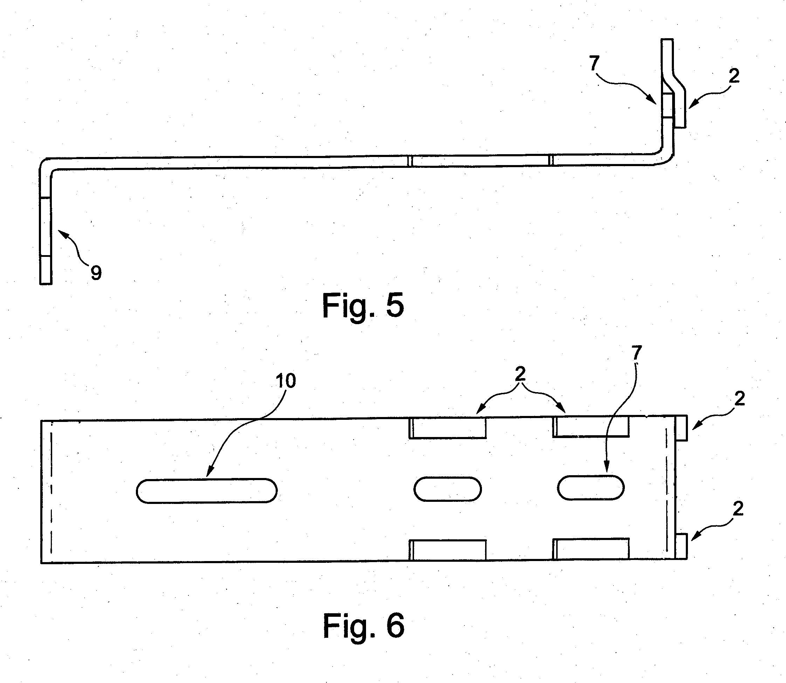

Eine solche Stütze zeigt die Fig. 5. Besonders günstig ist es, wenn die Stütze aus den gleichen Platinen gebogen wird, aus denen auch die erfindungsgemäßen Halter gebogen werden. In diesem Fall ist die Stütze mit Laschen versehen, wie sie auch die erfindungsgemäßen Halter tragen, sowie mit den entsprechenden Befestigungslöchern 7.

Anders, als die Halter 1 weisen die Stützen keine Hakenform auf, sondern im weitesten Sinne eine Z-Form. So wird in dem Bereich, der bei den Haltern 1 den Haken bildet, bei den Platinen, die Stützen bilden sollen, eine Abkantung vorgenommen, bevorzugt um 90°. Damit entsteht ein Schenkel, der gegen die tragende Struktur bzw. das Balkongeländer angelegt werden kann. Idealerweise trägt dieser Schenkel ein Loch oder genau das schon oben beschriebene Langloch 9, über das er an der tragenden Struktur festgesetzt werden kann.

Das andere Ende der Platinen wird zur Herstellung der Stützen ebenfalls abgekantet, ebenfalls bevorzugt um 90°. An diesem Ende sind schon ausgebildet, oder lassen sich nun aus den Laschen 2 nach unten geöffnete Haken ausbilden, die an dem abgekanteten Schenkel liegen. Diese werden hinter den unteren Rand des Profils eines zu haltenden Solarpanels oder Gegenstandes eingehakt, so dass das Solarpanel oder der zu haltende Gegenstand so gehalten werden und nicht verschwenken können.

Zwar nur optional, aber besonders praktisch ist die Verwendung der zur Herstellung der Halter gefertigten Platinen auch für die Herstellung der Stützen. Denn hierdurch können sehr einfach industriell oder auf der Baustelle vor Ort Stützen unterschiedlicher Länge gefertigt werden, da man alternativ abkanten kann. Auf diese Art und Weise lässt sich z. B. bei der Aufhängung von Solarpanelen an Balkongeländern effizient sicherstellen, dass die Paneele den baurechtlichen Vorschriften genügen und nie mehr als 10° gegenüber der Vertikalen geneigt sind.

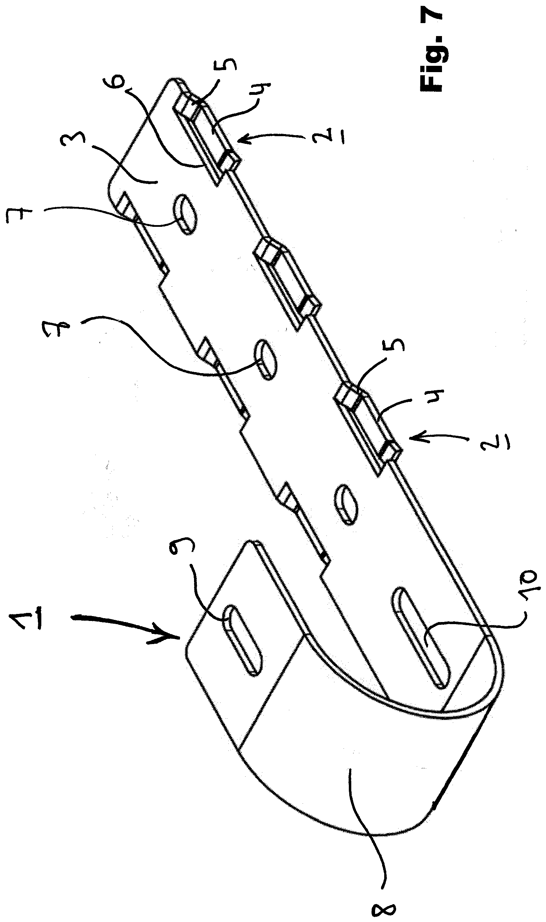

Die Figur 7 zeigt eine Variante des Ausführungsbeispiels. Sie zeichnet sich dadurch aus, dass jede Lasche 2 an seinem freien Ende, meist hinter dem Beginn des letzten Viertels, nochmals abgekantet ist um vorzugsweise 10° bis 20°, idealerweise nach unten weg vom restlichen Körper des Halters 1. Das erleichtert das Einführen der Lasche 2 in ihr Gegenstück erheblich. Darüber hinaus ist dieses Ausführungseispiel mit dem schon beschriebenen identisch, so dass das dort Gesagte entsprechend gilt

### BEZUGSZEICHENLISTE

- 1: Halter
- 2: Lasche
- 3: Montageflansch
- 4: Kopfabschnitt eines Hakens der Lasche
- 5: Kupplungsabschnitt eines Hakens der Lasche
- 6: Schlitz
- 7: Öffnung zum Verschrauben
- 8: Haken
- 9: weitere Öffnung
- 10: weitere Öffnung
- 11: Nut
- 12: Mikrosteg
- L: Längsachse

## Patentansprüche

1. Halter (1) zum Befestigen eines Solarmoduls an einer Stange, der ein zum Umgriff der Stange geeignetes Formschlusselement aufweist, bevorzugt in Gestalt eines Hakens (8), und der einen Halteflansch (3) ausbildet, der sicher mit dem zu haltenden Solarmodul verbunden werden kann, wobei der Halteflansch (3) mindestens eine Öffnung (7) besitzt, über die der Halteflansch (3) mit dem Solarpanel verschraubt oder vernietet werden kann, **dadurch gekennzeichnet, dass** der Halteflansch (3) mehrere Laschen (2) aufweist, die es ermöglichen, dass das besagte Solarmodul vor dem Verschrauben oder Vernieten formschlüssig in den Halteflansch (3) eingehängt wird.

2. Halter (1) zum Befestigen eines Solarmoduls nach Anspruch 1, **dadurch gekennzeichnet, dass** die Laschen (2) integraler Bestandteil des Halteflansches (3) sind.

3. Halter (1) zum Befestigen eines Solarmoduls nach Anspruch 1 oder 2, **dadurch gekennzeichnet, dass** der Haken (8) integral an den Halteflansch (3) angeformt ist.

4. Halter (1) zum Befestigen eines Solarmoduls nach einem der vorhergehenden Ansprüche, **dadurch gekennzeichnet, dass** der Halter (1) in Richtung senkrecht zu seiner Längsachse (L) mehrere nebeneinander angeordnete Laschen (2) aufweist.

5. Halter (1) zum Befestigen eines Solarmoduls nach einem der vorhergehenden Ansprüche, **dadurch gekennzeichnet, dass** die Laschen (2) im Auslieferungszustand nur an einem Ende integral mit dem Halteflansch (3) verbunden sind und ansonsten durch einen Schlitz (6) von ihm abgetrennt sind.

6. Halter (1) zum Befestigen eines Solarmoduls nach einem der vorhergehenden Ansprüche, **dadurch gekennzeichnet, dass** der Halteflansch (3) weitere in der Ebene des Halteflansches liegende Laschen aufweist.

7. Halter (1) zum Befestigen eines Solarmoduls nach einem der vorhergehenden Ansprüche, **dadurch gekennzeichnet, dass** ein freies Ende der Lasche in einer Ebene liegt oder in eine Ebene ragt, die vom Halteflansch (3) beabstandet ist.

8. Halter (1) zum Befestigen eines Solarmoduls nach einem der vorhergehenden Ansprüche, **dadurch gekennzeichnet, dass** die Lasche (2) einen Haken bildet, indem sie einen geradlinigen Kopfabschnitt (4) bilden, der parallel zum Halteflansch (3) ist, wobei sich an den Kopfabschnitt (4) ein Fußabschnitt (5) des Hakens anschließt, der Haken nur über den Fußabschnitt (5) mit dem Halteflansch (3) verbunden ist, und wobei der Fußabschnitt (5) schräg zu der vom Halteflansch (3) aufgespannten Ebene verläuft.

9. Halter (1) zum Befestigen eines Solarmoduls nach einem der vorhergehenden Ansprüche, **dadurch gekennzeichnet, dass** die zwei Laschen (2) außenseitig an der linken und rechten langen Stirnseite des Halteflansches (3) angeordnet sind.

10. Haltersystem mit mindestens einem Halter nach einem der Ansprüche 1 bis 9, **dadurch gekennzeichnet, dass** zu dem Haltersystem mindestens eine Stütze gehört, die das mit dem mindestens einen Halter aufgehängte Solarpaneel an einer von dem Halter beabstandeten Stelle am Balkongeländer oder Gebäude abstützt oder festlegt.

11. Haltersystem nach Anspruch 10, **dadurch gekennzeichnet, dass** die Stütze ein erstes im Wesentlichen um 90° abgebogenes oder abgekantetes Ende aufweist, das zur Anlage am Balkongeländer oder Gebäude ausgestaltet ist und bevorzugt mindestens ein Befestigungsdurchgangsloch aufweist

12. Haltersystem nach einem der Ansprüche 10 oder 11, **dadurch gekennzeichnet, dass** die Stütze ein zweites Ende besitzt, das im Wesentlichen um 90° abgebogen oder abgekantet ist und zur Anlage am Solarmodul ausgestaltet ist und bevorzugt zwei zu Haken gebogene Laschen aufweist, zum Hintergreifen einer Tragstruktur des Solarmoduls

13. Haltersystem nach einem der Ansprüche 10 bis 12, **dadurch gekennzeichnet, dass** die Stütze und der mindestens eine Halter (1) aus baugleichen, mit Laschen versehenen, ebenen Platinen gefertigt sind, durch unterschiedliches Verformen bzw. Abkanten.

14. Solarpaneleinheit zum Erzeugen von Strom, **dadurch gekennzeichnet, dass** das zugehörige Solarpanel mit mindestens einem Halter (1) nach einem der Ansprüche 1 bis 9 verbunden und vorzugsweise an einem Balkongeländer aufgehängt ist.

15. Solaranlage mit mindestens einem Solarpanel und einem Wechselrichter zum Umwandeln des von dem Solarpanel erzeugten Gleichstroms in einen Wechselstrom, **dadurch gekennzeichnet, dass** mindestens ein Solarpanel mit Haltern (1) nach einem der Ansprüche 1 bis 9 an einem Balkongeländer aufgehängt ist, wobei bevorzugt auch mindestens eine Stütze vorhanden ist, wie in den Ansprüchen 10 bis 11 bzw. 14 beschrieben.

## Claims

1. Holder (1) for attaching a solar module to a pole, comprising a positively engaging element suitable for grasping the pole, preferably in the form of a hook (8), and forming a holding flange (3) that can be securely connected to the solar module to be held, wherein the holding flange (3) has at least one opening (7) through which the holding flange (3) can be screwed or riveted to the solar panel, **characterized in that** the holding flange (3) has multiple tabs (2) that allow the solar module to be positively engaged in the holding flange (3) before screwing or riveting.

2. Holder (1) for attaching a solar module according to claim 1, **characterized in that** the tabs (2) are an integral part of the holding flange (3).

3. Holder (1) for attaching a solar module according to claim 1 or 2, **characterized in that** the hook (8) is integrally formed on the holding flange (3).

4. Holder (1) for attaching a solar module according to any of the preceding claims, **characterized in that** the holder (1) has multiple tabs (2) arranged side by side in a direction perpendicular to its longitudinal axis (L).

5. Holder (1) for attaching a solar module according to any of the preceding claims, **characterized in that** the tabs (2), in the delivered state, are integrally connected to the holding flange (3) only at one end and are otherwise separated from it by a slot (6).

6. Holder (1) for attaching a solar module according to any of the preceding claims, **characterized in that** the holding flange (3) has additional tabs lying in the plane of the holding flange.

7. Holder (1) for attaching a solar module according to any of the preceding claims, **characterized in that** a free end of the tab lies in a plane or protrudes into a plane that is spaced from the holding flange (3).

8. Holder (1) for attaching a solar module according to any of the preceding claims, **characterized in that** the tab (2) forms a hook by forming a straight head section (4) parallel to the holding flange (3), with a foot section (5) of the hook connecting to the head section (4), and the hook being connected to the holding flange (3) only through the foot section (5), wherein the foot section (5) is inclined to the plane defined by the holding flange (3).

9. Holder (1) for attaching a solar module according to any of the preceding claims, **characterized in that** the two tabs (2) are arranged on the outside of the left and right long end faces of the holding flange (3).

10. Holder system with at least one holder according to any of claims 1 to 9, **characterized in that** the holder system includes at least one support that supports or secures the solar panel suspended with the at least one holder at a location spaced from the holder on the balcony railing or building.

11. Holder system according to claim 10, **characterized in that** the support has a first substantially 90° bent or folded end designed to rest on the balcony railing or building and preferably has at least one fastening through-hole.

12. Holder system according to any of claims 10 or 11, **characterized in that** the support has a second end that is substantially bent or folded by 90° and is designed to rest on the solar module and preferably has two tabs bent into hooks for engaging a support structure of the solar module.

13. Holder system according to any of claims 10 to 12, **characterized in that** the support and the at least one holder (1) are made of identical flat plates provided with tabs, by different shaping or folding.

14. Solar panel unit for generating electricity, **characterized in that** the associated solar panel is connected with at least one holder (1) according to any of claims 1 to 9 and is preferably suspended on a balcony railing.

15. Solar system with at least one solar panel and an inverter for converting the direct current generated by the solar panel into alternating current, **characterized in that** at least one solar panel with holders (1) according to any of claims 1 to 9 is suspended on a balcony railing, preferably with at least one support as described in claims 10 to 11 or 14.

## Revendications

1. Support (1) pour fixer un module solaire à une tige, qui comporte un élément d'ajustement adapté à la prise de la tige, de préférence sous la forme d'un crochet (8), et qui forme une bride de maintien (3) pouvant être solidement reliée au module solaire à maintenir, la bride de maintien (3) possédant au moins une ouverture (7) à travers laquelle la bride de maintien (3) peut être vissée ou rivetée au panneau solaire, **caractérisé en ce que** la bride de maintien (3) comporte plusieurs languettes (2) permettant au module solaire en question d'être accroché de manière ajustée dans la bride de maintien (3) avant le vissage ou le rivetage.

2. Support (1) pour fixer un module solaire selon la revendication 1, **caractérisé en ce que** les languettes (2) sont une partie intégrante de la bride de maintien (3).

3. Support (1) pour fixer un module solaire selon la revendication 1 ou 2, **caractérisé en ce que** le crochet (8) est formé intégralement sur la bride de maintien (3).

4. Support (1) pour fixer un module solaire selon l'une des revendications précédentes, **caractérisé en ce que** le support (1) comporte plusieurs languettes (2) disposées côte à côte dans une direction perpendiculaire à son axe longitudinal (L).

5. Support (1) pour fixer un module solaire selon l'une des revendications précédentes, **caractérisé en ce que** les languettes (2) sont initialement connectées à une extrémité à la bride de maintien (3) et sont par ailleurs séparées de celle-ci par une fente (6) dans l'état de livraison.

6. Support (1) pour fixer un module solaire selon l'une des revendications précédentes, **caractérisé en ce que** la bride de maintien (3) comporte d'autres languettes situées dans le plan de la bride de maintien.

7. Support (1) pour fixer un module solaire selon l'une des revendications précédentes, **caractérisé en ce qu'**une extrémité libre de la languette se trouve dans un plan ou fait saillie dans un plan éloigné de la bride de maintien (3).

8. Support (1) pour fixer un module solaire selon l'une des revendications précédentes, **caractérisé en ce que** la languette (2) forme un crochet en formant une section de tête linéaire (4) parallèle à la bride de maintien (3), une section de pied (5) du crochet étant connectée à la section de tête (4), le crochet n'étant connecté à la bride de maintien (3) que par la section de pied (5), et la section de pied (5) étant inclinée par rapport au plan défini par la bride de maintien (3).

9. Support (1) pour fixer un module solaire selon l'une des revendications précédentes, **caractérisé en ce que** les deux languettes (2) sont disposées à l'extérieur sur les côtés longs gauche et droit de la bride de maintien (3).

10. Système de support avec au moins un support selon l'une des revendications 1 à 9, **caractérisé en ce que** le système de support comprend au moins un support qui soutient le panneau solaire suspendu avec le ou les supports à un endroit espacé du support sur la balustrade du balcon ou le bâtiment.

11. Système de support selon la revendication 10, **caractérisé en ce que** le support comporte une première extrémité pliée ou pliée de manière courbée à environ 90° destinée à venir en appui sur la balustrade du balcon ou le bâtiment et comporte de préférence au moins un trou de passage de fixation.

12. Système de support selon l'une des revendications 10 ou 11, **caractérisé en ce que** le support comporte une deuxième extrémité pliée ou pliée de manière courbée à environ 90° destinée à venir en appui sur le module solaire et comporte de préférence deux languettes pliées en crochets pour s'engager derrière une structure de support du module solaire.

13. Système de support selon l'une des revendications 10 à 12, **caractérisé en ce que** le support et le ou les supports (1) sont fabriqués à partir de plaques planes identiques pourvues de languettes, par déformation ou pliage différent.

14. Unité de panneaux solaires pour générer de l'électricité, **caractérisée en ce que** le panneau solaire associé est connecté à au moins un support (1) selon l'une des revendications 1 à 9 et est suspendu de préférence à une balustrade de balcon.

15. Installation solaire avec au moins un panneau solaire et un onduleur pour convertir le courant continu généré par le panneau solaire en courant alternatif, **caractérisée en ce qu'**au moins un panneau solaire est suspendu avec des supports (1) selon l'une des revendications 1 à 9 à une balustrade de balcon, de préférence avec au moins un support tel que décrit dans les revendications 10 à 11 ou 14.
